Europäisches Patentamt

European Patent Office

Office européen des brevets

(19)

(11) Veröffentlichungsnummer: **0 048 358**
**B1**

(12) **EUROPÄISCHE PATENTSCHRIFT**

(45) Veröffentlichungstag der Patentschrift:
24.09.86

(21) Anmeldenummer: **81106868.3**

(22) Anmeldetag: **02.09.81**

(51) Int. Cl.⁴: **H 01 L 29/10, H 01 L 21/18**

(54) **Integrierter Leistungstransistor.**

(30) Priorität: **19.09.80 DE 3035462**

(43) Veröffentlichungstag der Anmeldung:
**31.03.82 Patentblatt 82/13**

(45) Bekanntmachung des Hinweises auf die Patenterteilung:
**24.09.86 Patentblatt 86/39**

(84) Benannte Vertragsstaaten:
**DE FR GB IT**

(56) Entgegenhaltungen:
**DE-A-2 237 056**
**DE-A-2 332 144**
**GB-A-2 011 714**
**US-A-4 196 228**

**IEEE JOURNAL OF SOLID-STATE CIRCUITS, Band
SC-13, Nr. 3, Juni 1978, New York, B. MURARI "Power
Integrated Circuits: Problems, Tradeoffs, and
Solutions" Seiten 307-319**

(73) Patentinhaber: **Siemens Aktiengesellschaft Berlin
und München, Wittelsbacherplatz 2, D-8000
München 2 (DE)**

(72) Erfinder: **Mahrla, Peter, Dipl.- Phys.,
Treitschkestrasse 10, D-8000 München 50 (DE)**

## Beschreibung

Die Erfindung betrifft eine integrierte Leistungstransistoranordnung nach dem Oberbegriff des Anspruchs 1.

Beim Betrieb von bipolaren Leistungstransistoren ist die Schaffung einer gleichmäßigen Stromverteilung über den Gesamttransistor von großer Bedeutung hinsichtlich Betriebssicherheit und Lebensdauer eines solchen Bauelements.

Bei bipolaren Leistungstransistoren entsteht aufgrund des negativen Temperaturkoeffizienten der Basis-Emitter-Spannung eine laterale thermische Instabilität.

Für die Abhängigkeit der Kollektorstromdichte $J_C$ von der Temperatur T und der Basis-Emitter-Spannung $U_{BE}$ gilt näherungsweise:

$J_C = J_{Co} \cdot \exp((q \cdot U_{BE} - E_g)/kT)$

$J_{Co}$ = Proportionalitätsfaktor

q = Elementarladung

$E_g$ = Bandabstand bei Silicium ca. 1,1 eV k = Boltzmannkonstante

Erhöht sich in einem Transistor lokal die Temparatur relativ zur Umgebung, so resultiert bei fester Basis-Emitter-Spannung hieraus gemäß obiger Gleichung eine Erhöhung der lokalen Stromdichte. Dies führt zu einer ebenfalls lokalen Erhöhung der Freisetzung von Wärme als Verlustleistung an der Kollektor-Basis-Sperrschicht und im hochohmigen Teil des Kollektors. Durch die dadurch bedingte lokale Temperaturerhöhung wird ein Rückkopplungsmechanismus in Gang gesetzt, der zu einer Stromeinschnürung in Transistor führt. Die damit verbundene hohe lokale Wärmefreisetzung bedingt häufig eine irreversible Schädigung des Transistors, was zum Ausfall des Bauelements führt.

Derartigen Temperaturüberhohungen im Transistor muß durch eine geeignete Stromstabilisierung begegnet werden.

Aus IEEE Journal of Solid State Circuits, Vol. SC-13, No. 3, pages 307 to 319, June 78 ist es bekannt, eine Strombegrenzung in integrierten Leistungstransistoren dadurch vorzunehmen, daß die Emitterzone in mehrere Bereiche aufgeteilt ist, wobei der als Emitter hauptsächlich wirksame Bereich in der Nähe des Basisanschlusses nicht kontaktiert ist, sondern über mehrere, als Vorwiderstände wirkende Bereiche der Emitterzone mit kontaktierten Bereichen der Emitterzone verbunden ist, dergestalt, daß jedem Teilbereich der wirksamen Emitterzone ein Vorwiderstand und ein Anschluß zugeordnet ist. Durch den Spannungsabfall über diese Vorwiderstände wird eine gleichmäßige Stromverteilung über die einzelnen Teilbereiche der wirksamen Emitterzone erzielt, wobei der positive Temperaturkoeffizient des Emittervorwiderstandes unterstützend wirkt. Durch die in der genannten Literatur·stelle dargestellte Transistorstruktur ist außerdem auch ein Basisvorwiderstand neben dem Emittervorwiderstand gegeben. Der Basisvorwiderstand spielt jedoch neben dem Emittervorwiderstand keine entscheidende Rolle. Der Einbau von Emittervorwiderständen bedingt jedoch neben einer zusätzlich auftretenden Verlustleistung an den Emittervorwiderständen eine Erhöhung der Kollektor-Emitter-Restund Sättigungsspannung.

Aufgabe der vorliegenden Erfindung ist es daher, einen Leistungstransistor anzugeben, der einerseits eine hinreichend gleichmäßige Stromverteilung aufweist und andererseits eine möglichst geringe Sättigungs- bzw. Restspannung und Verlustleistung hat.

Diese Aufgabe wird bei der eingangs genannten Leistungstransistoranordnung mit den Merkmalen des kennzeichnenden Teils des Anspruchs 1 gelöst.

Eine besonders günstige Ausgestaltung dieser Maßnahme läßt sich in den Fällen erreichen, in denen die Spannung zwischen aktivem Basisbereich und kontaktiertem Basisbereich etwa doppelt so groß oder größer als der Spannungsabfall über den Emitterbereich ist.

Anstelle von Emittervorwiderständen zwischen wirksamem Emitterbereich und kontaktiertem Emitterbereich sind Basisvorwiderstände zwischen kontaktierten Basisbereichen und aktiven Basisbereichen eingebracht, so daß eine analoge Wirkung bezüglich der Wirkung von Emittervorwiderständen, nämlich eine gleichmäßige Verteilung des Basisstromes und damit auch des Emitterstromes erzielt wird. Ein positiver Temperaturkoeffizient der Basisvorwiderstände unterstützt diese Maßnahme.

Durch Anbringen von Basisvorwiderständen anstelle von Emittervorwiderständen kann in vorteilhafter Weise gleichzeitig eine zusätzliche Verlustleistung an den Emittervorwiderständen sowie eine Erhöhung der Kollektor-Emitter Restspannung und der Sättigungsspannung vermieden werden.

Die Basisvorwiderstände werden durch Verbindungszonen zwischen kontaktiertem Basisbereich und aktiven Basisbereichen derart verwirktlicht, daß die Verbindungszonen vom gleichen Dotierungstyp sind wie die Basiszone.

Diese Vorwiderstände lassen sich durch Diffusionen bzw. Implantationen erzielen, die bereits in der Prozeßfolge enthalten sind, die zur Herstellung der übrigen, in der integrierten Schaltung vorhandenen Bauelemente erforderlich sind, so daß keine zusätzlichen Prozeßschritte notwendig werden.

Die Basisvorwiderstände werden durch Einschnürungen des Basisbereichs zwischen den aktiven Basisbereichen und den kontaktierten Basisbereichen verwirklicht.

Durch diese Maßnahme lassen sich Vorwiderstände in der Basis einfach und ohne besonderen Arbeitsaufwand realisieren.

Es ist vorteilhaft, daß die Einschnürungen der Basisbereiche durch eine geeignete Gestaltung der Dotierungsmaske erzeugt werden. Vorwiderstände lassen sich somit allein durch eine geeignete Geometrie von Dotiermasken verwirklichen.

Zur Herstellung eines Leistungstransistors ist es auch vorteilhaft, daß in ein Substrat z.B. bestehend aus p-dotiertem Silicium, n+-dotierte Bereiche als buried Layer eingebracht werden, daß darüber eine Schicht z.B. bestehend aus n-dotiertem Silicium epitaktisch abgeschieden wird, daß in die epitaktisch abgeschiedene Schicht Isolationsdiffusionen und n+-dotierte Kollektortiefdiffusionen eingebracht werden, wobei die Reihenfolge dieser Diffusionen beliebig ist, daß danach in die epitaktische Schicht p-Dotierungen als Basiszone bzw. Basisvorwiderstände eingebracht werden, daß danach in die epitaktische Schicht n+-Dotierungen als Emitterzone sowie zum Zwecke einer guten Kontaktgabe der Kollektortiefdiffusionen eingebracht werden, daß Kontaktfenster hergestellt werden, daß Leitbahnen zur Kontaktierung angebracht werden.

Dieses Herstellungsverfahren eignet sich insbesonderezur Herstellung integrierter Leistungstransistoren. Die Dotierungen können hinsichtlich p und n auch spiegelbildlich erfolgen.

Nachfolgend wird die Erfindung anhand von Ausführungsbeispielen und der Zeichnung näher erläutert. Es zeigen:

Fig. 1 eine Draufsicht auf ein erstes Ausführungsbeispiel eines erfindungsgemäßen Halbleiterleistungstransistors,

Fig. 2 einen Querschnitt durch einen Halbleiterleistungstransistor nach Fig. 1 längs der Linie II-II.

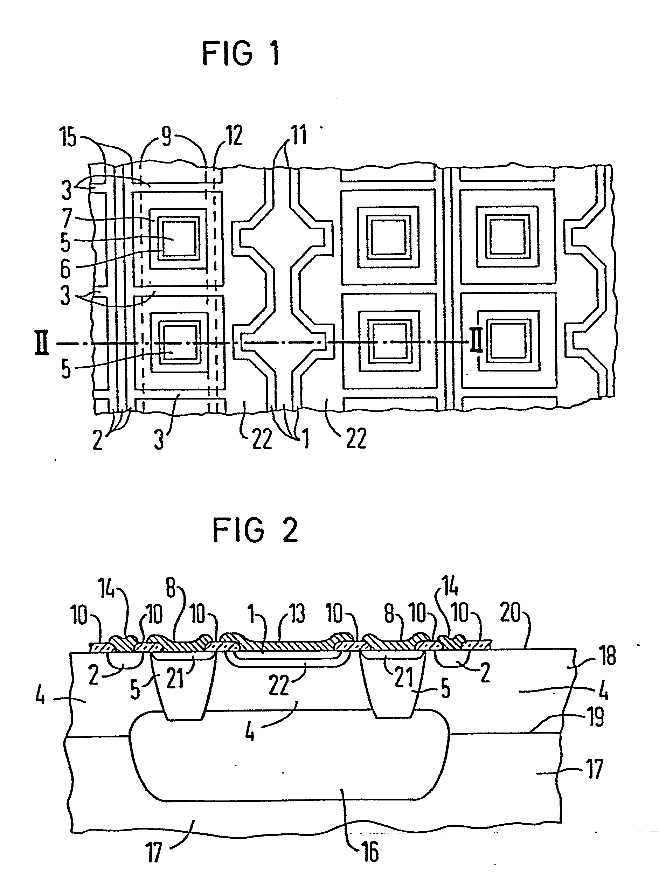

In den nachfolgenden Figuren 1 und 2 sind gleiche Gegenstände mit gleichen Ziffern belegt, weshalb die an einer Figur erläuterten Ziffern nicht an allen übrigen Figuren nochmals erläutert werden.

Fig. 1 stellt eine Draufsicht auf ein erstes Ausführungsbeispiel eines erfindungsgemäßen Halbleiterleistungstransistors in integrierter Form dar. Der Emitterbereich 1 wird von der Emitterleitbahn überlagert, die aus Gründen der Übersichtlichkeit in Fig. 1 nicht dargestellt ist.

Die Begrenzungslinien 12 der Emitterleitbahn sind durch gestrichelte Linien angedeutet. Innerhalb des Emitterbereiches 1 befindet sich das Emitterfenster, dessen Begrenzungslinien 11 durch ausgezogene Linien dargestellt sind. Die einzelnen Teilbereiche 22 bzw. 2 des Basisbereiches sind durch die Basisvorwiderstände 3 so miteinander verbunden, daß jeweils die kontaktierten Basisbereiche 2 durch die Basisvorwiderstände 3 mit den nichtkontaktierten Basisbereichen 22 verbunden werden. Die Basisvorwiderstände 3 im Falle von Fig. 1 und Fig. 2 sind durch stegartig eingeschnürte Basisbereiche verwirklicht. Die Basisleitbahn ist wiederum aus Gründen der Übersichtlichkeit nur durch deren strichliert gezeichnete Begrenzungslinien 15 dargestellt. Durch die Kollektor-Tief-Diffusionsbereiche 5 wird die buried Layer über die Kollektoranschlüsse 7 mit der Kollektorleitbahn, dargestellt durch die strichlierten Begrenzungslinien 9, verbunden.

Fig. 2 stellt einen Querschnitt des Halbleiterleistungstransistors nach Fig. 1 dar, wobei Fig. 1 längs der strichpunktierten Linie II-II geschnitten ist.

In einem Substrat 17, das z.B. aus Saphir oder einem Halbleiter, insbesondere Silicium bestehen kann, sind buried Layer Bereiche 16 eindotiert. Auf der Oberfläche 19 ist eine Epitaxieschicht 18 abgeschieden. Kollektor-Tief-Diffusionsbereiche 5 sind von der Oberfläche 20 so in die Epitaxieschicht 18 eingebracht, daß sie bis in die buried Layer 16 hineinragen. Oberhalb der buried Layer 16 zwischen den Kollektor-Tief-Diffusionsbereiche 5 befindet sich der Kollektorbereich 4. Darüber befindet sich der nichtkontaktierte Teil des Basisbereiches 22, der über die in Fig. 1 dargestellten Basisvorwiderstände 3 mit dem kontaktierten Basisbereich 2 verbunden ist. Die Kontaktierung des Basisbereiche 2 wird durch die Basisleitbahn 14 bewirkt. Zwischen nichtkontaktiertem Basisbereich 22 und der Oberfläche 20 ist der Emitterbereich 1 angebracht. Der Emitterbereich 1 ist durch die Emitterleitbahn 13 kontaktiert. Zur Kontaktierung der Kollektor-Tief-Diffusionsbereiche 5 sind die Kollektorleitbahnen 8 angebracht. Zum Zwecke einer guten Kontaktgabe zwischen Kollektorleitbahn 8 und Kollektor-Tief-Diffusionsbereich 5 sind zusätzliche dotierte Bereiche 21 in die Kollektor-Tief-Diffusionsbereiche 5 eingebracht, deren Dotierung im allgemeinen der Emitterdotierung entspricht. Zu Zwecken der Isolation zwischen den einzelnen Transistorbereichen und den zum Anschluß benötigten, darüber liegenden Leitbahnen 8, 13, 14 sind Oxidschichten 10 abgeschieden, die aus Gründen der Deutlichkeit in Fig. 1 jedoch nicht dargestellt sind.

Die Bezugszeichen der Figur 1 sind, um eine Verwechslung von zusammengehörigen Leitbahnbegrenzungslinien auszuschließen, einseitig zur Symmetrieachse der Anordnung angegeben.

Als Halbleitermaterial kann Silicium verwendet werden, in diesem Falle ist das Substrat 17 z.B. p-dotiert, die buried Layer 16 n+-dotiert, die Kollektor-Tief-Diffusionsbereiche 5 sind ebenfalls n+-dotiert sowie auch die Bereiche 21, die zum Anschluß der Kollektor-Tief-Diffusionen 5 an die Kollektorleitbahnen 8 dienen, sind ebenfalls n+-dotiert. Der Kollektor 4 sowie die gesamte Epitaxieschicht 18 sind n-dotiert, die Basisbereiche 2 bzw. 22 und die Basisvorwiderstände 3 sind jeweils p-dotiert

Der Emitterbereich 1 ist n+-dotiert. P-Dotierung kann im allgemeinen durch Dotierung mit Bor erfolgen, während n- bzw. n+-Dotierung mittels Arsen erfolgen kann. Es können jedoch auch andere geeignete Dotiermittel wie auch Halbleitermaterialien verwendet werden. Außerdem kam die Dotierung erfindungsgemäßer Halbleiterleistungstransistoren auch hinsichtlich p und n spiegelbildlich erfolgen.

Durch die Verwendung der Basisvorwiderstände zur Stromstabilisierung tritt der Spannungsabfall über den Basisvorwiderständen nicht in der Kollektor-Emitter-Sättigungsspannung auf, sondern lediglich in der Steuerspannung zwischen Basis und Ermitteranschluß. Durch die Verwendung von Basisvorwiderständen lassen sich nachteilige positive Temperaturkoeffizienten der Stromverstärkung teilweise kompensieren und zwar durch den positiven Temperaturkoeffizienten des Basiswiderstandes. Der positive Temperaturkoeffizient liegt in weiten Bereichen deutlich über dem der Stromverstärkung. Hierdurch wird zusätzlich eine Temperaturstabilisierung im Leistungstransistor erreicht, da an den heißen Stellen die Kollektor-Stromdichte und damit die Wärmefreisetzung durch den erhöhten widerstand vermindert wird.

Auch bei diskreten Leistungstransistoren ist eine dem Anmeldungsgegenstand gleiche Struktur realisierbar, wobei Kollektor-Tief-Diffusionen entfallen können.

Besonders vorteilhaft lassen sich erfindungsgemäße Halbleiterleistungstransistoren für Anwendungen im niederfrequenten Bereich einsetzen.

## Patentansprüche

1. Interrierte Leistungstransistoranordnung mit mehreren bipolaren, parallel geschalteten Teil-Leistungstransistoren,

bei der auf eiem Halbleitersubstrat (17) eine die jeweilige Kollektorzone der Teil-Leistungstransistoren bildende epitaktische Schicht (18) vorgesehen ist,

bei der im Bereich der Grenzfläche zwischen Halbleitersubstrat (17) und epitaktische Schicht (18) eine buried-layer-Zone (16) für den jeweiligen Kollektor (4) vorgesehen ist,

bei der von der dem Halbleitersubstrat (17) abgewandten Oberfläche (20) der epitaktischen Schicht (18) bis in die buried-layer-Zone (16) Teichende Kollektor-Anschlußbereiche (7) verlaufen,

bei der in der epitaktischen Schicht (18) an der dem Halbleitersubstrat abgewandten Seite eine den Teil-Leistungstransistoren gemeinsame Basiszone (2, 22) und in der Basiszone (2, 22) eine den Teil-Leistungstransistoren gemeinsame Emitterzone (1) vorgesehen ist

und bei der der jeweiligen Basis ein mitintegrierter Vorwiderstand vorgeschaltet ist, dadurch gekennzeichnet, daß die Basisvorwiderstände dadurch gebildet sind, daß die den Teil-Leistungstransistoren gemeinsame Basiszone (2, 22) von einem aktiven Basisbereich (22), der unterhalb der den Emitter der Teil-Leistungstransistoren bildenden Zone (1) liegt, streifenförmig abgehende Bereiche (3) aufweist, die durch Bereiche der epitaktischen Schicht (18), welche jeweils einen Kollektoranschlußbereich (7) eines Teil-Leistungstransistors bilden, begrenzt sind, und daß die streifenförmigen Bereiche (3) der Basiszone auf der der Emitterzone (1) abgewandten Seite der Kollektor-Anschlußbereiche (7) einen gemeinsamen Basiskontakt (2) aufweisen.

2. Integrierte Leistungstransistoranordnung nach Anspruch 1, dadurch gekennzeichnet, daß in den Kollektor-Anschlußbereichen (7) dotierte Zonen (5) vorgesehen sind, die von der dem Halbleitersubstrat abgewandten Oberfläche (20) der epitaktischen Schicht (18) bis in die buried-layer-Zone (16) reichen und zur Kollektorkontaktierung dienen.

3. Integrierte Leistungstransistoranordnung nach Anspruch 1 oder 2, dadurch gekennzeichnet, daß der Widerstandswert der durch die strei fenförmigen Bereiche (3) gebildeten Basisvorwiderstände durch ihre Länge in Richtung der Kollektor-Anschlußbereiche (7) und den Abstand jeweils zweier Kollektor-Anschlußbereiche (7) festgelegt ist.

## Claims

1. An integrated power transistor arrangement with a plurality of bipolar, component power transistors connected in parallel, wherein an epitaxial layer (18) which in each case forms the collector zone of the component power transistors is arranged on a semiconductor substrate (17),

wherein a buried layer (16) for the collector (4) in question is arranged in the region of the boundary between the semiconductor substrate (17) and the epitaxial layer (18),

wherein collector-terminal zones (7) extend from that surface (20) of the epitaxial layer (18) which faces away from the semiconductor substrate (17) into the buried layer (16),

wherein a base zone (2, 22), which is common to the component power transistors, is arranged in the epitaxial layer (18) on the side thereof facing away from the semiconductor substrate, and an emitter zone (1) which is common to the component power transistors is arranged in the base zone (2, 22),

and wherein a series resistor integrated with the base is connected in series with the base in question,

characterised in that the base series resistors are formed in that the base zone (2, 22) which is common to the component power transistors, of an active base zone (22) which is located beneath the zone (1) which forms the emitter of the component power transistors, has strip-like zones (3) which are delimited by zones of the epitaxial layer (18) which form a collector terminal zone (7) of a component power transistor; and that on that side of the collector terminal zones (7) facing away from the emitter zone (1), the strip-like zones (3) of the base zone have a common base contact (2).

2. An integrated power transistor arrangement as claimed in Claim 1, <u>characterised in</u> that doped zones (5) are provided in the collector terminal zones (7) and these zones extend from that surface (20) of the epitaxial layer (18) facing away from the semiconductor substrate into the buried layer (16) and serve to contact the collector.

3. An integrated power transistor arrangement as claimed in Claim 1 or Claim 2, <u>characterised in</u> that the resistance of the base series resistors formed by the strip-like zones (3), is fixed by their length in the direction of the collector terminal zones (7) and the distance between two collector terminal zones (7).

## Revendications

1. Dispositif intégré à transistors de puissance, comportant plusieurs transistors de puissance élémentaires bipolaires, et branchés en parallèle et dans lequel une couche épitaxiale (18), constituant la zone respective de collecteur des transistors de puissance élémentaire, est prévue sur un substrat semiconducteur (17), et dans lequel une zone formant couche ensevelie (16) est prévue pour le collecteur respectif (4) dans la région de l'interface entre le substrat semiconducteur (17) et la couche épitaxiale (18), et dans lequel la couche épitaxiale (18) s'étend à partir de la surface (20) située à l'opposé du substrat semiconducteur (17) jusque dans les régions de raccordement de collecteur (7) s'étendant à l'intérieur de la zone formant couche ensevelie (16), et dans lequel une zone de base (2, 22), qui est commune aux transistors de puissance élémentaires est prévue dans la couche épitaxiale (18) sur la face située à l'opposé du substrat semiconducteur, et qu'une zone d'émetteur (11) commune aux transistors de puissance élémentaires est prévue dans la zone de base (2, 22), et dans lequel une résistance additionnelle intégrée conjointement est branchée en amont de la base respective, caractérisé par le fait que les résistances additionnelles de base sont formées grâce au fait que la zone de base (2, 22) commune aux transistors de puissance élémentaires comporte des régions (3) s'étendant sous la forme de bandes à partir d'une région de base active (22), qui est située au-dessous de la zone (1) constituant l'émetteur des transistors de puissance élémentaires, et qui sont limités par les régions de la couche épitaxiale (18), qui forment respectivement une région de raccordement de collecteur (7) d'un transistor de puissance élémentaire, et que les régions en forme de bandes (3) de la zone de base comportent un contact de base commun (2) sur la face, située à l'opposé de la zone d'émetteur (1), des régions de raccordement de collecteur (7).

2. Dispositif intégré à transistors de puissance suivant la revendication 1, caractérisé par le fait que dans les régions de raccordement de collecteur (7) il est prévu des zones dopées (5) qui s'étendent depuis la surface (20), située à l'opposé du substrat semiconducteur, de la couche épitaxiale (18) jusqu'à la zone formant couche ensevelie (16) et sont utilisées pour établir les contacts de collecteur.

3. Dispositif intégré à transistors de puissance suivant la revendication 1 ou 2, caractérisé par le fait que la valeur des résistances additionnelles de base, formées par les régions en forme de bandes (3), est déterminée par leur longueur suivant la direction des régions de raccordement de collecteur (7) et par la distance respectivement de deux régions de raccordement de collecteur (7).

# FIG 1

# FIG 2